# EUROPÄISCHE PATENTSCHRIFT

(11) **EP 1 668 714 B1**
(45) Veröffentlichungstag und Bekanntmachung des Hinweises auf die Patenterteilung: **13.02.2008**
(21) Anmeldenummer: 04786879.9
(22) Anmeldetag: 29.09.2004
(51) Int. Cl.: H01L 41/24

(54) **Verfahren zur Herstellung eines keramischen Vielschicht-Bauelements**
Method of producing a ceramic multi-layer device
Procédé de fabrication d'un dispositif céramique à multicouches

(30) Priorität: 30.09.2003 DE 10345500
(43) Veröffentlichungstag der Anmeldung: 14.06.2006
(60) Teilanmeldung: 07017605.2
(73) Patentinhaber: EPCOS AG, 81669 München (DE)
(72) Erfinder: FLORIAN, Heinz, A-8524 Bad Gams (AT); OTTLINGER, Marion, A-8530 Deutschlandsberg (AT); SEDLMAIER, Peter, A-9113 Ruden (AT)
(74) Vertreter: Epping - Hermann - Fischer
(86) Internationale Anmeldenummer: PCT/DE2004/002167
(87) Internationale Veröffentlichungsnummer: WO 2005/034255

(56) Entgegenhaltungen:
- WO-A-02/06184
- WO-A-03/069689
- WO-A-03/073523
- DE-A1- 10 062 672
- DE-A1- 10 235 253
- US-A- 5 316 698
- US-A- 5 933 315
- US-A1- 2003 142 463

## Beschreibung

Verschiedene Verfahren zur Herstellung eines keramischen Vielschicht-Bauelements sind z. B. aus den Druckschriften DE 20023051.4, DE 10062672 A1, US 5,933,315, WO 02/06184 A1, WO 03/073523 A2, US 2003/0142463 A1, WO 03/069689 A2, US 5,316,698 und DE 10235253 A1 bekannt.

Aus der Druckschrift DE 9700463 ist ein Verfahren zur Herstellung von Grünfolien für piezokeramische Vielschichtbauelemente mit Ag/Pd-Innenelektroden bekannt, bei dem ein Piezokeramikpulver vom Typ PZT (PZT = Bleizirkonattitanat) eingesetzt wird.

Das Material bzw. das Verfahren zum Einbrennen der an die Innenelektroden kontaktierten Außenelektroden sollte im Prinzip so gewählt werden, daß einerseits das Elektrodenmetall nicht oxidiert und andererseits die Keramik nicht reduziert wird. Daher wird in der Regel ein Edelmetall bzw. eine Edelmetallegierung als Elektrodenmaterial verwendet.

In der Druckschrift DE 19945933 ist z. B. ein Verfahren zur Herstellung von Außenelektroden bei piezokeramischen Bauelementen auf der Basis der PZT-Keramik und der Ag/Pd-Innenelektroden beschrieben. Die Kontaktierung der Ag/Pd-Innenelektroden erfolgt mit einer Metallpaste mit einem Silbergehalt von > 65 % und einem organischen Binder, die bei ca. 700°C eingebrannt wird. Der Einbrand der Metallpaste wird in der Luftatmosphäre durchgeführt, da in dem organischen Pastenbinder enthaltene aromatische Verbindungen unter reduzierenden Bedingungen nicht vollständig zersetzt werden können. Dieses Verfahren ist jedoch für ein Vielschicht-Bauelement mit PZT-Keramik und kupferhaltigen Innenelektroden nicht geeignet, da bei den üblichen Entbinderungs- bzw. Einbrandtemperaturen nur unter einem bestimmten sehr niedrigen Sauerstoffpartialdruck von < 10⁻² Pa einerseits die PZT-Keramik nicht reduziert und andererseits metallisches Kupfer zugleich nicht oxidiert wird. Daher können die Ag/Pd-Außenelektroden in einem keramischen Vielschicht-Bauelement mit kupferhaltigen Innenelektroden nicht verwendet werden.

Mit einem aus der Druckschrift DE 20023051 U1 bekannten Bauelement gelingt es, den Nachteil der Kostenbelastung bei piezokeramischen Vielschichtbauelementen auf der Basis einer PZT-Keramik und Ag/Pd-Innenelektroden zu vermeiden, indem anstelle der teuren Ag/Pd-Innenelektroden kupferhaltige Innenelektroden verwendet werden. In dieser Druckschrift ist jedoch nicht erwähnt, welches Material zum Einbrennen von Außenelektroden in einem piezokeramischen Bauelement mit kupferhaltigen Innenelektroden geeignet ist.

Eine zu lösende Aufgabe besteht darin, ein Verfahren zur Herstellung eines keramischen Vielschicht-Bauelements anzugeben, bei dem die Keramik nicht reduziert wird und bei dem weder Innen- noch Außenelektroden oxidieren.

Es wird ein Verfahren zur Herstellung eines Vielschicht-Bauelements mit kupferhaltigen Elektroden angegeben, bei dem die Entbinderung bei einer Temperatur ≤ 300°C durchgeführt bzw. komplett abgeschlossen wird. Die Entbinderung erfolgt im Stickstoffstrom unter Zudosierung von Wasserdampf. Während der Entbinderung wird der Pegel des Sauerstoffpartialdrucks so gehalten, dass einerseits ein Druckwert pₘᵢₙ nicht unterschritten wird, bei dem die Keramik reduktiv zu degradieren anfängt, und andererseits ein Druckwert pₘₐₓ nicht überschritten wird, bei dem bei der gegebenen Temperatur das metallische Kupfer anfängt zu oxidieren.

Der Wasserdampfpartialdruck wird vorzugsweise so eingestellt, daß der ihm entsprechende Sauerstoffpartialdruck bei der gegebenen Temperatur zwischen den Gleichgewichtspunkten von Cu/Cu₂O und PbTiO₃/Pb liegt. Der Gleichgewichtspunkt entspricht einem solchen Sauerstoffpartialdruck, bei dem sowohl ein reduziertes Metall als auch eine diesem Metall entsprechende Metallverbindung thermodynamisch stabil sind und koexistieren können, ohne ineinander überzugehen. Durch das angegebene Verfahren wird ein keramisches Vielschicht-Bauelement mit einem Stapel alternierender Keramikschichten und als Innenelektroden dienender kupferhaltiger Elektrodenschichten hergestellt, wobei die Innenelektroden an Außenkontakte angeschlossen sind. Die Außenkontakte sind an einander gegenüberliegenden Außenseiten des Stapels senkrecht zu der Schichtanordnung angeordnet, wobei die zu verschiedenen Außenkontakten angeschlossenen Innenelektroden ineinander greifen. Das Vielschicht-Bauelement ist dadurch gekennzeichnet, daß die Außenkontakte metallisches Kupfer enthalten, wobei die Haftfestigkeit der Außenkontakte am Stapel mindestens 50 N beträgt.

Die Keramikschichten werden vorzugsweise aus keramischen Grünfolien hergestellt, die einen thermohydrolytisch abbaubaren Binder enthalten, und können eine ferroelektrische Perowskitkeramik mit der allgemeinen Zusammensetzung ABO₃, insbesondere vom PZT-Typ Pb(ZrₓTi_{1-X})O₃, umfassen.

Der Pastenbinder wird in einer reduzierten Atmosphäre von z. B. < 10⁻² Pa bei einer vergleichsweise niedrigen Temperatur ≤ 300°C vollständig gespaltet, da bei höheren Entbinderungstemperaturen der für die Verbrennung des im organischen Binder enthaltenen Kohlenstoffs unzureichende Sauerstoff zum Teil aus der Gitterstruktur der Keramik herausgezogen wird, was die Eigenschaften der Keramikschichten beeinträchtigt.

Eine vollständige Spaltung organischer Anteile wird dadurch ermöglicht, daß die Entbinderung im Stickstoffstrom unter Zudosierung von Wasserdampf durchgeführt wird, wobei eine hydrolytische Spaltung zustande kommt. Der Zusatz des Wasserdampfs bewirkt, daß der Sauerstoffpartialdruck thermodynamisch bedingt absinkt, wobei der Sauerstoffpartialdruck einen gewissen Wert jedoch nicht unterschreitet, bei dem die Keramik reduktiv zu degradieren anfängt.

Andererseits überschreitet der Sauerstoffpartialdruck auch nicht einen bestimmten Wert, bei dem bei der gegebenen Temperatur das metallische Kupfer anfängt zu oxidieren.

Der Sauerstoffpartialdruck wird also so niedrig gewählt, daß die Reduktionsprozesse in der Keramik noch hinreichend gehemmt sind und gleichzeitig das in der Metallpaste enthaltene Kupfer nicht mehr oxidiert.

Der Sauerstoffpartialdruck wird nicht nur beim Entbinderungsprozeß, sondern auch beim Einbrand der Metallpaste so gehalten bzw. zu jedem Zeitpunkt entsprechend der Temperatur derart angepaßt, daß er im p(T)-Diagramm bei jeder Prozeßtemperatur zwischen den Gleichgewichtspunkten von Cu/Cu₂O und Pb/PbO liegt.

Der Kupferanteil in der Metallpaste ist vorzugsweise > 70%. Als organischer Pastenbinder wird vorzugsweise Acrylharzbinder verwendet.

Das angegebene Verfahren ermöglicht die Verwendung einer (kupferhaltigen) Metallpaste mit einem organischen Pastenbinder zur Herstellung von Außenkontakten in einem piezokeramischen Bauelement mit kupferhaltigen Innenelektroden.

Zur Herstellung von Außenkontakten wird vorzugsweise eine kupferhaltige Metallpaste mit Kupfergehalt von > 70 m% (m% = Masseprozent), z. B. 78 m%, einem Glasfluß und einem organischen Binder, z. B. Acrylharzbinder, verwendet.

Der Glasfluß (Glasfritte) besteht vorzugsweise im wesentlichen aus PbO und SiO₂, kann jedoch auch weitere Bestandteile, z. B. Na₂O, Al₂O₃ und BaO aufweisen. Der Anteil des Glasflusses in der Metallpaste ist vorzugsweise kleiner als 5 m%. Die Zusammensetzung und der Anteil des Glasflusses werden so gewählt, daß die in der Metallpaste der Außenkontakte enthaltene Glasfritte teilweise in die Keramik eindiffundiert und dadurch die Haftfestigkeit der Außenkontakte an den Stapelseiten erhöht.

Zunächst wird in einem an sich bekannten Verfahren ein Stapel übereinander liegender Elektrodenschichten, die in einem fertigen Bauteil den Innenelektroden entsprechen, und Schichten aus einem Keramikmaterial erzeugt. Die Elektrodenschichten bestehen aus einer kupferhaltigen Metallpaste und können z. B. in einem Siebdruckverfahren auf die Schichten aus einem Keramikmaterial aufgetragen werden.

Die kupferhaltige Metallpaste wird ferner z. B. in einem Siebdruckverfahren auf einander gegenüberliegende Seiten des Stapels der übereinander liegenden Innenelektroden und Keramikschichten aufgebracht.

Die Metallpaste wird in einer feuchten Stickstoffatmosphäre in einem gasdichten Ofen bei einer Temperatur ≤ 300°C entbindert und anschließend bei einer höheren Temperatur gesintert.

Das Einbrennen der kupferhaltigen Metallpaste wird vorzugsweise zwischen 700 und 860°C durchgeführt.

Um Reduktion des in der Keramik enthaltenen Bleioxids zu verhindern, können bei der Herstellung eines Vielschicht-Bauelements Gitterunterlagen aus metallischem Kupfer verwendet werden, die gleichzeitig als Gettermaterial dienen.

Im folgenden wird die Erfindung anhand von Ausführungsbeispielen und der dazugehörigen Figuren näher erläutert. Es zeigen
- Figur 1: den Aufbau eines Vielchicht-Bauelements in perspektivischer Darstellung
- Figur 2: in halb-logarithmischer Darstellung die Abhängigkeit des unter der Zudosierung des Wasserdampfes einzustellenden Sauerstoffpartialdruckes von der Temperatur und die Gleichgewichtskurven von Cu/Cu₂O und Pb/PbTiO₃

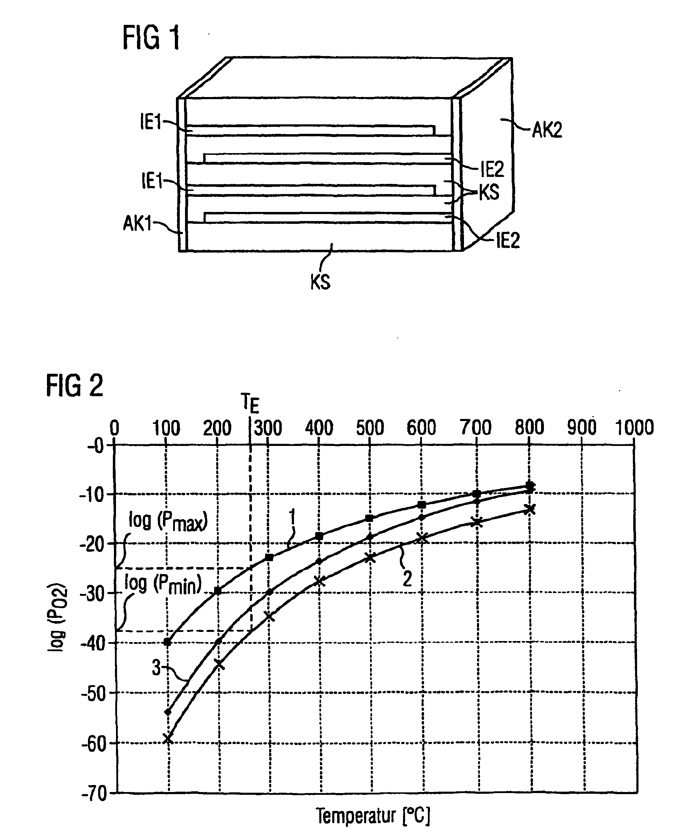

In Figur 1 ist ein keramisches Bauelement mit kupferhaltigen Außenkontakten AK1 und AK2 schematisch gezeigt. An den ersten Außenkontakt AK1 sind erste kupferhaltige Innenelektroden IE1 angeschlossen. An den zweiten Außenkontakt AK2 sind zweite kupferhaltige Innenelektroden IE2 angeschlossen. Die Innenelektroden sind voneinander durch Keramikschichten KS getrennt.

Die Keramikschichten KS weisen vorzugsweise piezoelektrische Eigenschaften auf und sind z. B. auf der Basis der Keramik des PZT-Typs hergestellt.

Das dargestellte Bauelement realisiert insbesondere einen Piezoaktor. Die übereinander gestapelten Elektrodenschichten und Keramikschichten werden als Piezostack bezeichnet.

Die eingebrannten Außenkontakte AK1, AK2 sind vorzugsweise zwischen 10 und 20 µm, z. B. 15 µm dick. Es kann aber auch eine andere Dicke der Außenkontakte gewählt werden.

Die Außenkontakte und/oder Innenelektroden weisen vorzugsweise einen bestimmten Keramik-Anteil, der vorzugsweise kleiner als 50 m% (m% = Masseprozent) ist, in einer bevorzugten Variante zwischen 10 und 50 m% liegt und insbesondere 40 m% beträgt, auf. Der Keramik-Anteil weist dabei Keramikpartikel mit einer bestimmten Korngröße, z. B. mit einer mittleren Korngröße zwischen 0,2 und 0,6 µm auf.

Der Keramik-Anteil in der Metallpaste verhindert insbesondere Rißbildung und Abhebung des Außenkontakts vom Piezostack, welche sich aufgrund unterschiedlicher Ausdehnungseigenschaften des Keramikmaterials und des metallischen Kupfers ergeben.

Der thermische Ausdehnungskoeffizient der Keramik des PZT-Typs beträgt im Temperaturbereich zwischen der Raumtemperatur und der Curie-Temperatur ca. 1,5 - 2,0 ppm/K, während metallisches Kupfer im entsprechenden Temperaturbereich einen wesentlich höheren thermischen Ausdehnungskoeffizienten von ca. 19 ppm/K aufweist. Durch Zumischung des Keramikmaterials in die Metallpaste wird das Ausdehnungsverhalten des Außenkontakts an das Ausdehnungsverhalten des Keramikstapels sowohl während der Prozessierung des Bauteils als auch für dessen spätere Anwendungen im spezifizierten Temperaturbereich von z. B. -50°C bis +150°C, wobei z. B. durch Anlegen eines elektrischen Feldes eine Deformation des Bauelements entsteht, angepaßt.

Zur Anpassung der thermischen Ausdehnungskoeffizienten wird vorzugsweise eine Glasfritte mit einem hohen SiO₂-Anteil von z. B. 39 m% verwendet, da SiO₂ eine hohe Affinität zur Keramik des PZT-Typs aufweist.

Bei der Zubereitung der kupferhaltigen Metallpaste wird zunächst ein Keramikpulver mit einer mittleren Korngröße von z. B. 0,4 µm in einer Dispersion mit einem Lösungsmittel fertiggestellt. Anschließend wird die Keramikpulver-Dispersion in die kupferhaltige Metallpaste der oben schon angegebenen Zusammensetzung eingerührt und mit Hilfe eines Dreiwalzenwerkes homogenisiert. Die Viskosität der Metallpaste beträgt vorzugsweise zwischen 10 und 20 Pas. Nach dem Aufbringen der fertigen Metallpaste auf die Seitenflächen des Piezostacks wird die Paste bei ca. 80 bis 140°C in der Luftatmosphäre getrocknet. Ferner erfolgt Entbinderung und Sintern unter angegebenen Verfahrensbedingungen, wobei einerseits die Oxidation des metallischen Kupfers und andererseits die Reduktion des PbO oder PbTiO₃ verhindert werden. Dabei wird insbesondere im Hinblick auf die Auswahl der Entbinderungstemperatur und die Dauer der Entbinderung darauf geachtet, daß während des Entbinderungsprozesses aus der Metallpaste nicht nur die Binderanteile, sondern auch die Lösungsmittelreste vollständig ausgebrannt werden.

Da die in der Metallpaste enthaltene Glasfritte zum Teil sehr stark in die Keramik eindiffundiert und dabei in den gesinterten Keramikschichten Hohlräume hinterläßt, wird die Sintertemperatur so niedrig (z. B. 765°C) gewählt, daß das Eindringen des Glaszusatzes nur im Bereich der Innenelektroden stattfindet. Mikroskopische Untersuchungen belegen, daß bei einer derart gewählten Sintertemperatur Glasanteile, vor allem Siliziumoxid, nur in einem an die Außenkontakte angrenzenden engen Bereich der Keramikschichten feststellbar sind. Die Außenkontakte haften fest und lassen sich nur unter Anwendung einer großen Kraft von über 50 N vom Piezostack ablösen. Bei der gewaltsamen Ablösung der Außenkontakte werden Teile des Keramikmaterials herausgebrochen, was für eine hohe Haftfestigkeit der Außenkontakte am Piezostack spricht.

Der Keramik-Anteil beträgt vorzugsweise 40 m% bezogen auf den Feststoffgehalt der Metallpaste. Diese Metallpaste kann im Prinzip auch für innen liegende Elektrodenschichten verwendet werden.

Im Rahmen der Erfindung liegt es auch, in der Elektrodenmetallisierung ein vorzugsweise chemisch aktives Keramikpulver (oder auch einen anderen chemisch aktiven Zusatzstoff), im Folgenden auch Keramikzusatz genannt, vorzusehen, das unter bestimmten Bedingungen chemisch mit dem Elektrodenmetall, dem organischen Binder, der Keramik und/oder einem Reaktionsprodukt dieser reagieren bzw. bestimmte Komponenten chemisch binden kann. Ferner kann der Keramikzusatz mit der Prozeßatmosphäre reagieren, z. B. den Sauerstoff an die Prozeßatmosphäre abgeben oder umgekehrt aufnehmen, wodurch zumindest lokal bzw. vorübergehend der Sauerstoffpartialdruck stabilisiert wird. Mit einem stabilen Sauerstoffpartialdruck gelingt es insbesondere, die innen liegenden Elektrodenschichten bzw. die Außenkontakte vor Oxidation und die Keramikschichten vor Reduktion zu schützen. Der Keramikpulver-Zusatz sorgt dafür, daß ein durch Prozeßinstabilitäten in der Elektrodenmetallisierung entstandenes Metalloxid gebunden wird, wodurch ein unerwünschtes Eindiffundieren dieses Metalloxids in die Keramikschichten vermieden wird.

Die Verwendung eines chemisch inerten Keramikpulvers in einer Metallpaste z. B. zur Verzögerung der Sinterung des Metalls ist an sich bekannt. Erfindungsgemäß wird das Keramikpulver jedoch als funktionelles Additiv verwendet, das chemisch aktiv ist und mit seiner Umgebung chemisch reagieren kann. Die chemische Aktivität kann z. B. auf die Bindung von Pb, das bei der Sinterung aus der bleihaltigen Keramikmasse freigesetzt wird, gerichtet sein. Möglich ist es auch, daß das chemisch aktive Keramikpulver eine andere Komponente der Keramikmasse insbesondere bei der Sinterung bindet oder zur Freisetzung von bestimmten Komponenten wie z. B. Sauerstoff aus der Keramikmasse oder aus dem in der Keramikmasse oder in der Metallpaste enthaltenen Binder dient. Voraussetzung ist jedoch, daß das Keramikpulver mit dem Metallanteil der Metallpaste nicht chemisch reagiert.

Im Gegensatz zu der Metallpaste, die bei den Außenelektroden verwendet wird, werden in der für die Innenelektroden-Schichten geeigneten Metallpaste vorzugsweise keine Glaszusätze verwendet. Als chemisch aktives Keramikpulver ist insbesondere (Zr,Ti)O₂ geeignet. Die Metallpaste kann anstelle eines chemisch aktiven Keramikpulver auch einen anderen chemisch aktiven Zusatzstoff oder zusätzlich zu dem chemisch aktiven Keramikpulver Anteile von weiteren Stoffen enthalten, z. B. BaO₂ und/oder MgO.

Der Zusatz eines Keramikpulvers bei den Innenelektroden sorgt außerdem für eine bessere Haftung zwischen der Innenelektrode und den diese umgebenden Keramikschichten, wobei durch eine feine Verteilung der Keramikpartikel zwischen den Metallpartikeln insbesondere die Sinterhalsbildung verhindert wird. Die Sinterhälse stellen eine lokale Unterbrechung der Innenelektrode dar, wobei sich die Metallisierung von der Keramikschicht löst und/oder - vor allem im Randbereich - zurückgezogen wird, so daß die Innenelektrode eine netzförmige Struktur annimmt, deren Struktur von Bauteil zu Bauteil nicht reproduzierbar ist. Es ist bekannt, daß eine homogene Innenelektrodenstruktur auch durch den Zusatz eines Edelmetalls oder einer Edelmetallegierung erreicht werden kann. Der erfindungsgemäße Zusatz des Keramikpulvers hat demgegenüber aber einen großen Kostenvorteil.

In der Figur 2 ist in halb-logarithmischer Darstellung ein in Abhängigkeit von der Temperatur -unter Zudosierung des Wasserdampfes - einzustellender Sauerstoffpartialdruck pₒ₂, beispielsweise gegeben durch die Kurve 3, die numerisch berechnete Gleichgewichtskurve 1 von Cu und Cu₂O und die numerisch berechnete Gleichgewichtskurve 2 von Pb und PbTiO₃ gezeigt.

Die Gleichgewichtskurve 1 gibt bei der ausgewählten Temperatur den Partialdruck von O₂ an, bei dem metallisches Cu und Cu₂O gleichzeitig existieren können. Metallisches Kupfer existiert nur bei einem Sauerstoffpartialdruck pₒ₂, der den Gleichgewichtswert nicht übersteigt, d. h. unterhalb der Gleichgewichtskurve 1. Da oberhalb der Kurve 1 nur Cu₂O stabil ist, erfolgt bei einem Sauerstoffpartialdruck, der den Gleichgewichtswert bei der ausgewählten Temperatur übersteigt, eine unerwünschte Oxidation des metallischen Kupfers.

Die Gleichgewichtskurve 2 gibt bei der ausgewählten Temperatur den Partialdruck von O₂ an, bei dem metallisches Pb und PbTiO₃ gleichzeitig existieren können. PbTO₃ existiert nur oberhalb der Kurve 2. Bei einem Sauerstoffpartialdruck pₒ₂, der den Gleichgewichtswert bei der ausgewählten Temperatur unterschreitet, wird das in der Keramik enthaltene PbTiO₃ zu Pb reduziert.

Daher wird zumindest in der Entbinderungsphase eines erfindungsgemäßen Verfahrens zur Herstellung eines keramischen Vielschicht-Bauelements der Sauerstoffpartialdruck pₒ₂ unter Zudosierung von Wasserdampf so eingestellt, daß er einerseits den durch die Kurve 1 definierten Maximalwert pₘₐₓ, bei dem metallisches Kupfer noch stabil ist, nicht übersteigt, und anderseits den durch die Kurve 2 gegebenen Minimalwert pₘᵢₙ, bei dem Bleititanat noch nicht reduziert wird, nicht unterschreitet, d. h. pₘᵢₙ < pₒ₂ < pₘₐₓ bei der gegebenen Entbinderungstemperatur T_{E}. Der zulässige Bereich zur Einstellung des Sauerstoffpartialdruckes liegt also zwischen den Kurven 1 und 2.

Die Kurve 3 beschreibt einen je nach Temperatur und in einer feuchten Atmosphäre einzustellenden, erfindungsgemäß aufgefundenen, optimalen Sauerstoffpartialdruck. Die Menge des hinzuzufügenden Wasserdampfes kann im Prinzip aus der Kurve 3 berechnet werden. Möglich ist es auch, den Abfall des Sauerstoffpartialdrucks unter Zudosierung von Wasserdampf manuell oder automatisch so zu steuern, daß die vorgegebenen Grenzwerte nicht verletzt werden.

### Bezugszeichenliste

- 1: Kennlinie des Gleichgewichts von Cu und Cu₂O im Diagramm log{p(O₂)} gegen Temperatur
- 2: Kennlinie des Gleichgewichts von Pb und PbTiO₃ im Diagramm log{p(O₂)} gegen Temperatur
- 3: Kennlinie des unter Zudosierung von Wasserdampf einzustellenden Sauerstoffpartialdrucks in Abhängigkeit von Temperatur
- AK1, AK2: Außenkontakt
- KS: Keramikschicht
- IE1: an den Außenkontakt AK1 angeschlossene Innenelektroden
- IE2: an den Außenkontakt AK2 angeschlossene Innenelektroden
- pₒ₂: Sauerstoffpartialdruck
- pₘᵢₙ: minimaler zulässiger Sauerstoffpartialdruck
- pₘₐₓ: maximaler zulässiger Sauerstoffpartialdruck
- T_{E}: Entbinderungstemperatur

## Patentansprüche

1. verfahren zur Herstellung eines Vielschicht-Bauelements mit Keramikschichten und dazwischen liegenden kupferhaltigen Innenelektroden, die an kupferhaltige Außenkontakte angeschlossen sind,
bei dem die Entbinderung bei einer Temperatur ≤ 300°C im Stickstoffstrom unter Zudosierung von Wasserdampf durchgeführt und dabei der Entbinderungsprozeß komplett abgeschlossen wird,
wobei während der Entbinderung der Pegel des Sauerstoffpartialdrucks so gehalten wird, dass er einen Wert pₘᵢₙ nicht unterschreitet, bei dem die Keramik reduktiv zu degradieren anfängt, und einen Wert pₘₐₓ nicht überschreitet, bei dem bei der gegebenen Temperatur das metallische Kupfer anfängt zu oxidieren.

2. Verfahren nach Anspruch 1,
wobei pₘᵢₙ dem Gleichgewichtspunkt von Cu/Cu₂O entspricht,
wobei pₘₐₓ dem Gleichgewichtspunkt von Pb/PbO oder Pb/PbTiO₃ entspricht.

3. Verfahren nach Anspruch 1 oder 2,
bei dem zur Herstellung von Außenkontakten eine kupferhaltige Metallpaste mit einem Kupfergehalt von > 70 Masseprozent, einer Glasfritte und einem organischen Binder verwendet wird.

4. Verfahren nach Anspruch 3,
bei dem als organischer Binder Acrylharzbinder verwendet wird.

5. Verfahren nach Anspruch 3 oder 4,
bei dem die Glasfritte im wesentlichen PbO und SiO₂ enthält.

6. Verfahren nach einem der Ansprüche 3 bis 5,
bei dem die kupferhaltige Metallpaste zwischen 700 und 860°C eingebrannt wird.

7. Verfahren nach Anspruch 6,
bei dem die Entbinderung und das Einbrennen der kupferhaltigen Metallpaste auf einer Kupferunterlage durchgeführt wird.

8. Verfahren nach einem der Ansprüche 3 bis 7,
bei dem die kupferhaltige Metallpaste in einem Siebdruckverfahren aufgebracht wird.

9. Verfahren nach einem der Ansprüche 1 bis 8,
bei dem zur Erzeugung der Innenelektroden-Schichten eine Metallpaste mit einem Anteil eines chemisch aktiven Zusatzstoffs verwendet wird,
wobei der chemisch aktive Zusatzstoff zumindest mit einer Komponente seiner Umgebung außer dem Metallanteil der Metallpaste chemisch reagiert.

10. Verfahren nach Anspruch 9,
bei dem als der chemisch aktive Zusatzstoff ein chemisch aktives Keramikpulver verwendet wird.

11. Verfahren nach Anspruch 9 oder 10,
bei dem die Komponente der Umgebung ausgewählt ist aus dem Sauerstoff, zumindest einem Bestandteil der Keramikmasse und einem in der Metallpaste oder der Keramikmasse enthaltenen Binder oder Lösungsmittel.

12. Verfahren nach einem der Ansprüche 9 bis 11,
bei dem bleihaltige Keramikmasse verwendet wird,
bei dem infolge einer chemischen Reaktion zwischen dem chemisch aktiven Zusatzstoff und seiner Umgebung Sauerstoff freigesetzt und/oder Pb und/oder Cu gebunden wird.

13. Verfahren nach einem der Ansprüche 9 bis 12,
bei dem als chemisch aktiver Zusatzstoff zumindest ein Zusatzstoff verwendet wird, ausgewählt aus (Zr, Ti)O₂, MgO und BaO₂ .

## Claims

1. Method of producing a multilayer device with ceramic layers and copper-containing internal electrodes lying in between that are connected to copper-containing external contacts, whereby
the debinding is carried out at a temperature ≤ 300°C in a nitrogen stream whilst adding water vapour by metered addition, thereby entirely completing the debindering process,
whereby, during the debinding, the level of the oxygen partial pressure is maintained such that it does not fall below a pressure value pₘᵢₙ at which reductive degradation of the ceramic begins and such that it does not exceed a pressure value pₘₐₓ at which, at the given temperature, oxidization of the metallic copper begins.

2. Method according to Claim 1, whereby pₘᵢₙ corresponds to the equilibrium point of Cu/Cu₂O and whereby pₘₐₓ corresponds to the equilibrium point of Pb/PbO or Pb/PbTiO₃.

3. Method according to Claim 1 or 2, whereby a copper-containing metal paste with a copper content of > 70 per cent by mass, and with glass frit and an organic binder is used for producing external contacts.

4. Method according to Claim 3, whereby acrylic resin binder is used as the organic binder.

5. Method according to Claim 3 or 4, whereby the glass frit substantially contains PbO and SiO₂.

6. Method according to one of Claims 3 to 5, whereby the copper-containing metal paste is burned in between 700 and 860°C.

7. Method according to Claim 6, whereby the debinding and the burning in of the copper-containing metal paste is carried out on a copper underlay.

8. Method according to one of Claims 3 to 7, whereby the copper-containing metal paste is applied in a screen printing process.

9. Method according to one of Claims 1 to 8, whereby a metal paste with a proportion of a chemically active additive is used for producing the layers of internal electrodes, and whereby the chemically active additive chemically reacts with at least one component of its surroundings apart from the metal component of the metal paste.

10. Method according to Claim 9, whereby a chemically active ceramic powder is used as the chemically active additive.

11. Method according to Claim 9 or 10, whereby the component of the surroundings is selected from the oxygen, at least one constituent of the ceramic mass and a binder or solvent contained in the metal paste or the ceramic mass.

12. Method according to one of Claims 9 to 11, whereby lead-containing ceramic mass is used and whereby oxygen is released and/or lead and/or copper-bound as a result of a chemical reaction between the chemically active additive and its surroundings.

13. Method according to one of Claims 9 to 12, whereby at least one additive selected from (Zr, Ti)O₂, MgO and BaO₂ is used as the chemically active additive.

## Revendications

1. Procédé de production d'un composant à couches multiples ayant des couches en céramique et entre elles des électrodes intérieures contenant du cuivre, qui sont reliées à des contacts extérieurs contenant du cuivre,
dans lequel on effectue l'élimination du liant à une température ≤ 300°C dans le courant d'azote avec addition dosée de vapeur d'eau et on achève ainsi complètement le processus d'élimination du liant,
dans lequel, pendant l'élimination du liant, on maintient le niveau de la pression partielle de l'oxygène de manière à ne pas venir en dessous d'une valeur Pₘᵢₙ, à laquelle la céramique commence à se dégrader par réduction et à ne pas dépasser une valeur Pₘₐₓ, à laquelle à la température donnée le cuivre métallique commence à s'oxyder.

2. Procédé suivant la revendication 1
dans lequel Pₘᵢₙ correspond au point d'équilibre de Cu/Cu₂O dans lequel Pₘₐₓ correspond au point d'équilibre de Pb/PbO ou de Pb/PbTiO₃.

3. Procédé suivant la revendication 1 ou 2,
dans lequel, pour la production de contacts extérieurs, on utilise une pâte métallique contenant du cuivre ayant une teneur en cuivre de >70% en poids, une frite de verre et un lien organique.

4. Procédé suivant la revendication 3,
dans lequel on utilise un liant en résine acrylique comme liant organique.

5. Procédé suivant la revendication 3 ou 4,
dans lequel la frite de verre contient essentiellement du PbO et du SiO₂.

6. Procédé suivant l'une des revendications 3 à 5,
dans lequel la pâte métallique contenant du cuivre est cuite entre 700 et 860°C.

7. Procédé suivant la revendication 6,
dans lequel on effectue l'élimination du liant et la cuisson de la pâte métallique contenant du cuivre sur un support en cuivre.

8. Procédé suivant l'une des revendications 3 à 7,
dans lequel on dépose la pâte métallique contenant du cuivre par un procédé de sérigraphie.

9. Procédé suivant l'une des revendications 1 à 8,
dans lequel, pour la production de couches d'électrodes intérieures, on utilise une pâte métallique ayant une proportion d'un additif actif chimiquement,.
dans lequel l'additif actif chimiquement réagit chimiquement au moins sur un constituant de son environnement à l'exception de la partie métallique de la pâte métallique.

10. Procédé suivant la revendication 9,
dans lequel on utilise comme additif actif chimiquement une poudre de céramique active chimiquement.

11. Procédé suivant la revendication 9 ou 10,
dans lequel on choisit le constituant de l'environnement parmi l'oxygène au moins un constituant de la composition céramique et un liant ou un solvant contenu dans la pâte métallique ou dans la composition de céramique.

12. Procédé suivant l'une des revendications 9 à 11,
dans lequel on utilise une composition céramique contenant du plomb, dans lequel, en raison d'une réaction chimique entre l'additif actif chimiquement et son environnement, il se dégage de l'oxygène et/ ou du Pb et/ou du Cu est fixé.

13. Procédé suivant l'une des revendications 9 à 12,
dans lequel on utilise comme additif actif chimiquement au moins un additif choisi parmi (Zr, Ti)O₂, MgO et BaO₂.
